# EUROPEAN PATENT APPLICATION

(11) **EP 1 300 917 A1**
(43) Date of publication of application: **09.04.2003**
(21) Application number: 01308464.5
(22) Date of filing: 03.10.2001
(51) Int. Cl.: H01S 5/227

(54) **Semiconductor device with current confinement structure**

(71) Applicant: Agilent Technologies, Inc. (a Delaware corporation), Palo Alto, CA 94303 (US)
(72) Inventor: Ryder, Paul David, Ipswich, Suffolk IP1 3JP (GB); Berry, Graham Michael, Bury St. Edmunds IP33 1JL (GB); Massa, John Stephen, Ipswich, Suffolk IP1 3JP (GB)
(74) Representative: Coker, David Graeme

(57) **Abstract**

The present invention relates to a semiconductor device (1) with one or more current confinement regions (20) and to a method of manufacturing such a device, particularly buried heterostructure light emitting devices such as semiconductor lasers and light emitting diodes. The device comprising a doped semiconductor substrate (2) of a first conduction type, a buried heterojunction active layer (10) above the substrate (2), a current conduction region (4) above the active layer (10), one or more current confinement regions (20) formed over the substrate (2) adjacent the active layer (10), the current conduction region (4) and current confinement region (20) being arranged in use to channel electric current to the active layer (10). Each current confinement region (20) includes a reverse-biased diode junction (9;119) current blocking structure (17,18), and between said structure and the substrate (2) a graded second conduction type current blocking layer (7;107) in contact with the reverse-biased diode structure. The graded second conduction type current blocking layer (7,107) has a dopant concentration that falls from the reverse-biased diode structure (17,18) towards the substrate (2).

## Description

The present invention relates to a semiconductor device with one or more current confinement regions and to a method of manufacturing such a device, particularly buried heterostructure light emitting devices such as semiconductor lasers and light emitting diodes.

The fabrication and use of laser diodes in a buried heterostructure was achieved many years ago. In the field of transmitter devices for fibre-optic communication, operation is required from 1.3 to 1.6 µm, and so such opto-electronic transmitter devices are usually fabricated from a wafer grown from an n-InP substrate on which are grown a number of layers, including an undoped InGaAsP active layer, sandwiched between an upper p-InP cladding layer and a lower n-InP buffer layer. A mask is applied to the upper cladding layer, and the surrounding layers are etched to leave a mesa structure.

Buried heterostructure light emitting devices commonly have current confinement regions defined by areas of high resistivity that are grown to cover the sides of the mesa and which channel current to an optically active layer within the mesa structure.

A mask defining the mesa is then removed, and further layers are grown up to a p⁺-InGaAs ternary cap layer. The ternary cap layer has a relatively low resistance, and so serves as a contact layer to which electrical contacts may be made.

In devices using InGaAsP/InP materials, current confinement regions have often been employed based on a reverse-biased p-n or n-p diode structure. Such structures provide high resistivity, and low leakage currents, and are widely used in fibre optic communication systems across a range of operating frequencies. At operating frequencies about 1 GHz, however, the performance of such devices becomes limited by the capacitance of the current blocking structure, owing to the charge on the reverse biased diode junction.

The static performance of such buried heterostructure devices having p-n (or equivalently n-p) reverse-biased current-blocking structures, and particularly the leakage currents, and slope efficiencies, has been shown to depend on the properties of the current leakage path through the current blocking layers. The maximum modulation speed, for high frequency operation depends mainly on the capacitance of such layers.

In recent years there has been an increasing demand for fibre optic communication links having a bandwidth in excess of 1 GHz, for example up to 10 GHz. It is an object of the present invention to provide a semiconductor device that addresses these issues.

Accordingly, the invention provides a semiconductor device comprising a doped semiconductor substrate of a first conduction type, a buried heterojunction active layer above said substrate, a current conduction region above the active layer, one or more current confinement regions formed over the substrate adjacent the active layer, the current conduction region and current confinement region being arranged in use to channel electric current to the active layer, wherein the or each current confinement region includes:
a) a diode junction current blocking structure, said junction having a doped first conduction type current blocking layer, and between the first conduction type current blocking layer and the substrate a doped second conduction type current blocking layer, said blocking layers forming in use a reverse biased diode junction to inhibit current flow through the current confinement region; and
b) beneath the second conduction type current blocking layer a graded second conduction type current blocking layer in contact with the second conduction type current blocking layer, the graded second conduction type current blocking layer having a dopant concentration that falls from the second conduction type current blocking layer towards the substrate.

The first conduction type may be an n-type doped semiconductor material, in which case the second conduction type is a p-type doped semiconductor material. Alternatively, the first conduction type may be a p-type doped semiconductor material, in which case the second conduction type is an n-type doped semiconductor material.

It has been found that the graded second conduction type current blocking layer helps to stabilise the n-type and p-type semiconductor composition, including dopant concentrations, in the layers either side of the graded layer. Semiconductor or dopant materials can migrate from one layer to another during manufacturing stages for the semiconductor device. For example, when semiconductor layers are grown using MOCVD processes, previously deposited layers can reach a temperature of around 650 °C. These elevated temperatures can cause dopants or semiconductor elements from one layer to migrate into an adjacent layer, thus changing the electrical properties of the layers and the junction between the layers.

It has been found that by introducing the graded second conduction type current blocking layer in contact with the second conduction type current blocking layer, the material structure across the diode junction is stabilised. It has been discovered that the reason for this is that the graded layer inhibits cross-migration of dopant or semiconductor materials between the second conduction type current blocking layer into an underlying first conduction type layer. Migration of first conduction type materials into the second conduction current blocking type layer is believed to destabilise the structure at typical processing temperatures, cause a secondary migration of the second conduction type materials from the second conduction type current blocking layer across the diode junction into the first conduction type current blocking layer.

When the doped semiconductor materials are selected from III-V elements, for example indium and phosphorous, then sulphur can be used to form an n-type dopant, and zinc can be used to form a p-type dopant. The graded layer is then a zinc-doped layer. The structure has then been found to at least partially inhibit migration of indium from the layer beneath the graded layer up into the zinc-doped p-type layer. Such migration of indium during manufacture has been found to promote migration of the zinc-dopant out of the p-type layer, both upwards across the diode junction into the neighbouring n-type layer, and downwards towards the n-type substrate. Therefore, by inhibiting at least partially this initial migration of relatively mobile indium into the p-type layer, the graded dopant-concentration layer helps to stabilise the composition across the diode junction, so preserving good static performance for the device.

In a preferred embodiment of the invention, the current confinement structure includes an undoped layer between the first conduction type current blocking layer, and the second conduction type current blocking layer. Introducing the graded second conduction type current blocking layer reduces the diffusion of the second conduction type materials into this undoped layer, preserving the thickness of the undoped layer. This reduces the capacitance of the reverse biased junction and improves the high frequency performance of the device.

The undoped layer also presents a further barrier to changes in the chemical composition of the first conduction type current blocking layer, that may be caused by migration of material into the first conduction type current blocking layer from the second conduction type current blocking layer. Used in conjunction with the graded dopant concentration layer, the undoped layer helps to reduce further any changes in the composition across the diode junction that would tend to reduce the static performance of the device.

Preferably, the thickness of the second conduction type current blocking layer is between 400 nm and 1 µ, and the thickness of the graded second conduction type layer is between 50 nm and 250 nm.

Because the substrate may be formed a boule that has a certain level of undesirable lattice defects, it is preferred if the device includes between the substrate and the graded second conduction type current blocking layer, a first conduction type layer grown on the substrate. Such a grown first type layer can therefore serve as a "buffer" layer with a lower level of defects than the underlying substrate.

The device may include a buried mesa structure having one or more side walls that rise above the substrate. The active layer may then extend to the or each side wall. It is then preferred if the active layer is covered at the side walls by the graded second conduction type current blocking layer. The graded layer then helps to prevent migration of material between the second conduction type current blocking layer and the active layer, in a similar manner to that described above.

This reduces optical losses and results in lower threshold current and increased slope efficiency.

The invention also provides a method of forming semiconductor device comprising an active layer, a current conduction region, one or more current confinement regions adjacent the current conduction region, the current conduction region and current confinement region being arranged to channel electric current to the active layer, wherein the method comprises the steps of:
i) growing upon a semiconductor substrate a plurality of semiconductor layers, including the active layer and the current conduction region by which electric current may be applied to the active layer;
ii) growing adjacent the active layer a diode junction current blocking structure, said junction having a doped first conduction type current blocking layer, and between the first conduction type current blocking layer and the substrate a doped second conduction type current blocking layer, said blocking layers forming in use a reverse biased diode junction to inhibit current flow through the current confinement region; and
iii) growing beneath the second conduction type current blocking structure a graded second conduction type current blocking layer in contact with the second conduction type current blocking layer, the graded second conduction type current blocking layer having a dopant concentration that falls from the second conduction type current blocking layer towards the substrate.

The invention will now be described by way of example, with reference to the accompanying drawings, in which:
Figure 1 is a schematic cross-section of a buried heterostructure semiconductor laser device according to a first embodiment of the invention, comprising an active layer within a buried mesa stripe, a current conduction region for channelling current to the active layer, and current confinement regions consisting of a reverse biased diode junction structure underlain by a graded dopant concentration;
Figures 2 to 4 show process steps for creating the semiconductor laser device according to the invention; and
Figures 5 is a schematic cross-section of a buried heterostructure semiconductor laser device according to a second embodiment of the invention, similar to that of the first embodiment, but including also an undoped spacer layer in the diode junction;

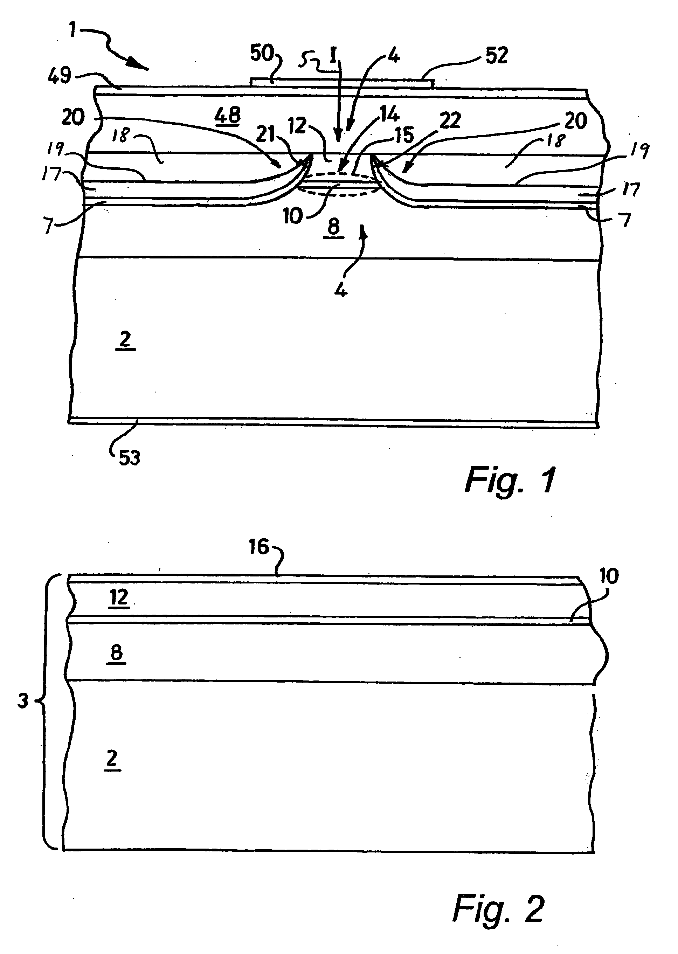

Figure 1 shows, not to scale, a cross-section of a semiconductor device 1 according to the invention, here a buried heterostructure laser diode suitable for use as a transmitter in a high speed fibre-optic link operating between 1.3 and 1.6 µm. Currently, high speed links operate at 2.5 or 10 Gbits/s.

Referring now also to Figure 2, the device 1 is formed starting from a wafer 3 that is 32 mm square, and that has an n-InP substrate 2 doped to around 10¹⁹ cc⁻¹, on which is grown a number of III-V semiconductor layers, using well-known MOCVD techniques. The p-type dopant is zinc, and the n-type dopant is sulphur.

The first grown layer is a 2 µm thick n⁻-InP buffer layer 8 doped to around 10¹⁸ cc⁻¹. An active layer 10 is grown on the buffer layer 8 according to known techniques for fabricating planar active lasers for a laser diode - the active layer could be a bulk region or a strained multiple quantum well (SMQW) structure. An example of an SMQW device is discussed in W. S. Ring et al, Optical Fibre Conference, Vol. 2, 1996 Technical Digest Series, Optical Society of America. The type of active layer employed is not critical to the invention.

In the present example, the laser diode 1 has a quaternary InₓGa₁₋ₓAs_{1-y}P_{y} active layer 10 that may be between about 100 nm to 300 nm thick. The active layer 10 is topped by a cladding layer 12, formed from p⁺-InP, grown to be between about 100 nm to 1 µm thick.

Although not illustrated a DFB grating for the laser diode 1 can be contained in the n-InP buffer layer 8 or in the p-InP cladding layer 12.

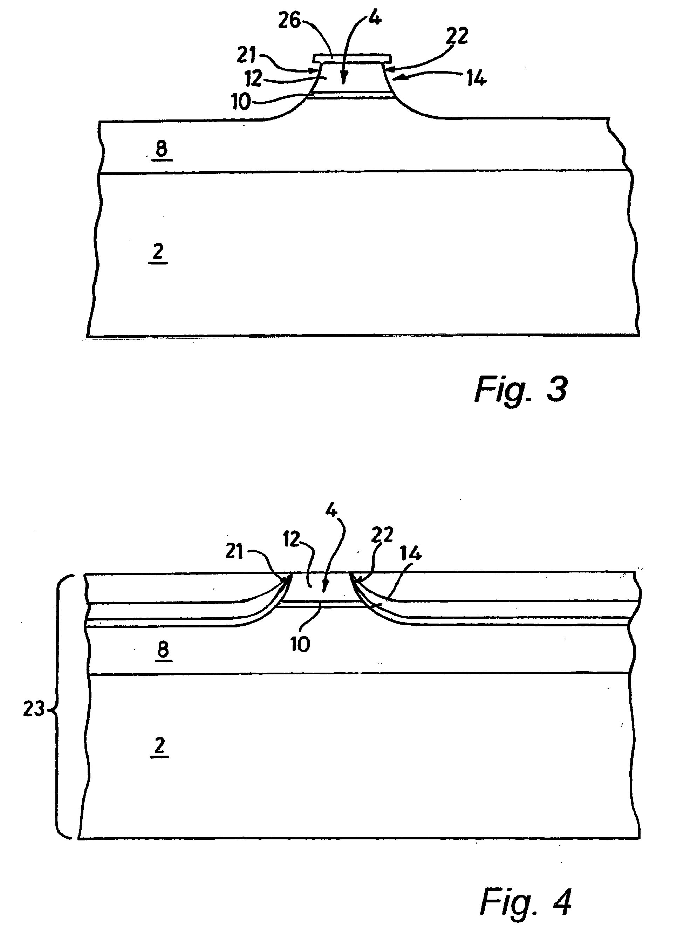

Then, using well-known fabrication technology, the wafer 3 is coated with an oxide layer 16 as shown in Figure 2. The oxide layer may be SiO₂ deposited by a plasma enhanced chemical vapour deposition (PECVD) process. It should, however, be noted that silicon nitride would be a suitable alternative choice to SiO₂. As shown in Figure 3, the oxide layer 16 is photolithographicly patterned with a photoresist to leave a patterned mask 26, and etched to remove, in areas not covered by the patterned mask, the cladding layer 12, the active layer 10, and all but 200 nm of the buffer layer 8. In this example layers 8, 10 and 12 are removed in a wet-etch process that undercuts the patterned mask 26.

The grown layers 8,10 and 12 are removed in all areas except along a mesa stripe 14 structure that extends perpendicular to the plane of the drawing, and which rises above the level of'the substrate 2. The mesa stripe 14 has left and right opposite side walls 21,22 that together with the buffer layer 8 and the cladding 12 form a current conduction region 4 for an applied current 5 (I), and have the effect of guiding an optical mode 15 along the active layer 10 within the stripe 14.

The wet etch process produces mesa side walls 21,22 that slope laterally away from the active layer.

The width of the mesa stripe 14 varies depending on the particular device, but for opto-electronic devices such as laser diodes, the ridge stripe 14 is usually between 1 µm and 10 µm wide. The ridge strip 14 rises 1 µm to 2 µm above the surrounding substrate 2.

A current blocking structure 20 is then grown on the etched device up to approximately the level of the patterned mask 26. The structure 20 includes a first p-doped InP layer 7 having a graded dopant concentration that drops off exponentially from at least about 1x10¹⁸ cc⁻¹ towards the buffer layer 8, and then a second p-doped InP layer 17 having a substantially constant dopant concentration at least as high as the highest dopant concentration in the graded p-type layer 7. Finally, an n-doped InP layer 18 is grown directly on the p-type layer 17. The thicknesses of the p-doped layer is about 0.5 µm and the thickness of the n-doped layer is about 0.4 µm. These InP layers 17,18 form a p-n junction 19 that in use is reverse biased and hence insulating when the conduction region 4 is forward biased.

The graded layer 7 should be between about one-tenth and one-half the thickness of the above layer, that is between about 50nm and about 250 nm.

After deposition of the first current blocking structure 20, the PECVD oxide layer 16 is removed with 10:1 buffered HF from the ridge strip 14 to expose again the cladding layer 12. This leaves an etched and coated wafer 23 comprising the substrate 2, the mesa stripe 14 and the first current blocking structure 20 abutting the opposite sides 21,22 of the mesa stripe 14.

A cladding layer 48 formed from p⁺-InP is then grown above the cladding layer 12 and current blocking structure 20 to a thickness of about 2 µm to 3 µm. The final semiconductor layer is a 100 nm to 200 nm thick ternary cap layer 49 deposited on the cladding layer 48. The cap layer 49 is formed from p⁺⁺-GaInAs, highly doped to around 10¹⁹ cc⁻¹, in order to provide a good low resistance ohmic contact for electrical connection to the current conduction region 4 of the mesa stripe 14. As an alternative to a ternary cap layer, it is possible to use a quaternary InGaAsP cap layer, or both InGaAsP and InGaAs layers.

During processing of grown layers 17,18,48,49 above the graded layer 7, the device 1 may experience temperatures as high at 650 °C. As explained above, the graded layer 7 helps stabilise the chemical composition of the adjacent layers 8,17, and hence helps to prevent migration of zinc in the p-type layer 17 across the p-n junction 19.

Standard metal layers 50 are then vacuum deposited on the cap layer 49 using well known techniques, followed by metal wet etch in photolithographically defined areas. The remaining metal forms a contact pad 52 with good ohmic contact through the cap layer 49.

The resulting wafer is then thinned to a thickness of about 70 µm to 100 µm in a standard way, in order to assist with cleaving. Standard metal layers 53 are then deposited by sputtering on the rear surface of the wafer, so enabling electrical contact to be made to the n-side of the devices.

The wafer is then inscribed and cleaved in a conventional process first transversely into bars about 350 µm wide, and then each bar is cleaved into individual devices 200 µm wide. The cleaved device 1 is about 350 µm long (i.e. in the direction of the mesa 14) and about 200 µm wide.

Although not shown, after testing the device 1 may be packaged in an industry standard package, with a single mode optical fibre coupled with a spherical lens to an output facet of the laser diode, and with gold bond wires soldered onto the metalised contact 52.

The InGaAsP/InP device 1 described above therefore incorporates a current confinement region formed from a reverse-biased p-n structure having beneath the structure a graded dopant layer that helps to control the doping profiles throughout the rest of the structure. Therefore, as will be described in further detail below, the invention provides a high resistivity current confinement region, and low leakage currents, across a wide range of operating temperatures. The invention also permits the use of higher drive voltages, which are useful in achieving high-speed operation.

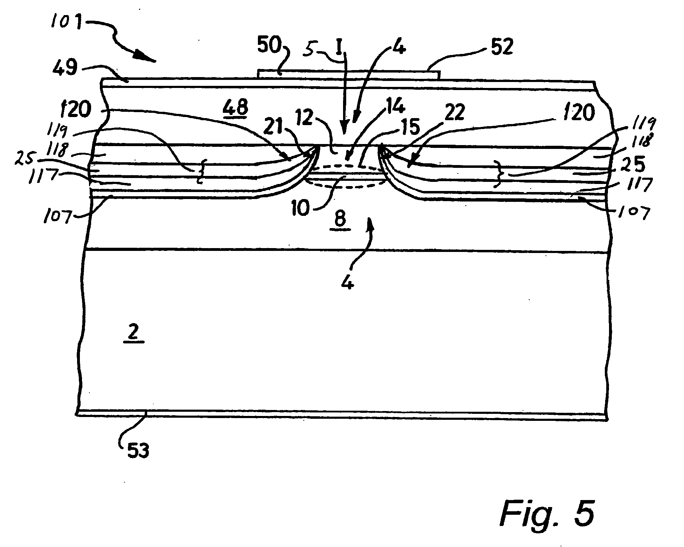

Figures 5 shows how the process described above may be modified, in a second embodiment 101 of the invention, where features corresponding with those of Figures 1 to 4 are given similar reference numerals incremented by 100. The process used to create the second embodiment 101 differs from that used to create the first embodiment 1 in that an additional InP undoped layer 25 is grown between the lower p-type current blocking layer 117 and the upper n-type current blocking layer 118. The purpose of the undoped layer 25 is to reduce the capacitance of the reverse biased junction between the p-type and n-type layers, in order to improve the high frequency performance of the device. The undoped layer 25 is preferably between 400nm and 1µm thick.

In both embodiments 1,101, the mesa structure 14 has side walls 21,22 that slope outwardly away from the active layer 10 towards the current confinement structure 20,120. This helps the graded layer 7 grow up the sides 21,22 of the mesa 14, which helps to reduce migration of doping or semiconductor materials between the mesa 14 and the current blocking structure 20,120 materials.

The doping concentration in the graded layer 7,107 may be produced by varying the process conditions during the growth of this layer. Alternatively, a graded doping concentration can also be achieved by depositing an undoped layer, if the temperatures reached in subsequent processing steps are sufficient to result in a diffusion of dopant material from the subsequent current blocking layer 17,117 down into the initially undoped layer beneath.

In order to test the efficiency of the laser diodes according to the invention, dc measurements of the slope of the light output vs drive current were made at 25 °C and at 85 °C. The slopes at drive currents of 100 mA were measured and then divided by the slopes just above the threshold current (around 6 mA at 25 °C, and 20 mA at 85 °C). The ratio of these slopes is a measure of the device's efficiency, which was determined to be 0.95 at 25 °C and 0.80 at 85 °C. For devices of this sort, efficiency figures such as this are considered to be very good.

Semiconductor devices according to the invention provide a high operating bandwidth and good lifetime characteristics. The process steps involved may be similar to other standard steps used in the fabrication of such devices. There is no need for additional expensive processing equipment.

Although the present invention has been described specifically for the example of a laser diode, the invention is applicable to any high speed semiconductor device where current blocking regions help to channel current through a current conduction region, for example ridge waveguide type lasers, pump lasers, edge emitting light emitting diodes, edge photodetectors, surface emitting laser and light emitting diodes, and top-entry photodetectors. Another example is an optical waveguide with a split into two waveguides at a Y-junction. This may have electrically driven or modulated active optical regions in two or three of the arms of the "Y", for example an optical amplifier or modulator. It may then be desirable to provide a current blocking region at the junction of the three arms, where there may be three separate conduction regions.

The invention may also be used with additional current blocking layers, for example either above, or to the side of the blocking regions discussed above. The invention may also be used with trenched blocking structures.

The invention described above have been described for a device based on an n-InP substrate, having a first current blocking structure formed from a reverse biased p-n junction in laterally adjacent contact with the active layer structure. However, it is to be appreciated that the invention can also be applied to other types of devices, for example those based on a p-InP substrate. In this case, the first current blocking structure may be a reverse biased n-p junction, and the graded current blocking layer would be formed from an n-type material.

## Claims

1. A semiconductor device (1;101) comprising a doped semiconductor substrate (2) of a first conduction type, a buried heterojunction active layer (10) above said substrate (2), a current conduction region (4) above the active layer (10), one or more current confinement regions (20;120) formed over the substrate (2) adjacent the active layer (10), the current conduction region (4) and current confinement region (20;120) being arranged in use to channel electric current to the active layer (10), wherein the or each current confinement region (20;120) includes:
a) a diode junction (19;119) current blocking structure (20;120), said junction having a doped first conduction type current blocking layer (18;118), and between the first conduction type current blocking layer and the substrate (2) a doped second conduction type current blocking layer (17;117), said blocking layers (17,18;117,118), forming in use a reverse biased diode junction (19;119) to inhibit current flow (5) through the current confinement region (20;120); and
b) beneath the second conduction type current blocking layer (17;117) a graded second conduction type current blocking layer (7;107) in contact with the second conduction type current blocking layer (17;117), the graded second conduction type current blocking layer (7,107) having a dopant concentration that falls from the second conduction type current blocking layer (17;117) towards the substrate (2).

2. A semiconductor device (101) as claimed in Claim 1, in which the current confinement structure (120) includes an undoped layer (25) between the first conduction type current blocking layer (18;118), and the second conduction type current blocking layer (17;117).

3. A semiconductor device (1;101) as claimed in Claim 1 or Claim 2, in which the device (1;101) includes between the substrate (2) and the graded second conduction type current blocking layer (7;107) a first conduction type layer (8) grown on the substrate (2).

4. A semiconductor device (1;101) as claimed in any preceding claim, in which the device (1;101) includes a buried mesa structure (14,114) having one or more side walls (21;22) that rise above the substrate (2), with the active layer (10) extending to the side wall(s) (21,22) and the active layer (10) being covered at the side walls (21,22) by the graded second conduction type current blocking layer (7;107).

5. A semiconductor device (1;101) as claimed in Claim 4, in which the mesa side walls (21,22) slope laterally away from the active layer (10) towards the current confinement structure (20;120).

6. A semiconductor device (1;101) as claimed in any preceding claim, in which the first conduction type is an n-type doped semiconductor material, and the second conduction type is a p-type doped semiconductor material.

7. A semiconductor device (1;101) as claimed in Claim 6, in which the doped semiconductor materials are selected from III-V elements, with sulphur forming an n-type dopant, and zinc forming a p-type dopant.

8. A semiconductor device (1;101) as claimed in any preceding claim, in which the thickness of the second conduction type current blocking layer (17;117) is between 400 nm and 1 µ, and the thickness of the graded second conduction type layer (7;107) is between 50 nm and 250 nm.

9. A semiconductor device (1;101) as claimed in any preceding claim, in which the dopant concentration in the graded second conduction type layer (7;107) falls exponentially from the second conduction type current blocking layer towards the substrate (2).

10. A semiconductor device (1;101) as claimed in any preceding claim, in which the dopant concentration in the second conduction type current blocking layer (17;117) is at least 1x10¹⁸ cc⁻¹.

11. A semiconductor device (1;101) as claimed in any previous claim, in which the device (1;101) is a buried heterostructure laser diode device.

12. A method of forming semiconductor device (1;101) comprising an active layer (10), a current conduction region (4), one or more current confinement regions (20;120) adjacent the current conduction region (4), the current conduction region (4) and current confinement region (20;120) being arranged to channel electric current (5) to the active layer (10), wherein the method comprises the steps of:
i) growing upon a semiconductor substrate (2) a plurality of semiconductor layers, including the active layer (10) and the current conduction region (4) by which electric current (5) may be applied to the active layer (10);
ii) growing adjacent the active layer (10) a diode junction (19;190) current blocking structure (20;120), said junction (19,119) having a doped first conduction type current blocking layer (18;118), and between the first conduction type current blocking layer (18;118) and the substrate (2) a doped second conduction type current blocking layer (17;117), said blocking layers (17,18;117;118) forming in use a reverse biased diode junction (19;119) to inhibit current flow (5) through the current confinement region (20;120); and
iii) growing beneath the second conduction type current blocking structure (20,120) a graded second conduction type current blocking layer (7;107) in contact with the second conduction type current blocking layer (17;117), the graded second conduction type current blocking layer (7;107) having a dopant concentration that falls from the second conduction type current blocking layer (17;117) towards the substrate (2).
